# EUROPÄISCHE PATENTSCHRIFT

(11) **EP 0 898 444 B1**
(45) Veröffentlichungstag und Bekanntmachung des Hinweises auf die Patenterteilung: **03.11.2004**
(21) Anmeldenummer: 98114988.3
(22) Anmeldetag: 11.08.1998
(51) Int. Cl.: H05K 7/20

(54) **Gehäuse zur Aufnahme von elektrischen Baugruppen**
Cabinet for electrical equipment
Boîtier pour loger des équipements électriques

(30) Priorität: 18.08.1997 DE 29714762 U
(43) Veröffentlichungstag der Anmeldung: 24.02.1999
(73) Patentinhaber: SIEMENS AKTIENGESELLSCHAFT, 80333 München (DE)
(72) Erfinder: Niggl, Heinz-Jürgen, 82343 Poecking (DE); Schwind, Stefan, 82140 Olching (DE); Buchberger, Georg, 81476 München (DE); Hannigan, Matthew-T, San Jose, CA 95123 (US)
(74) Vertreter: Berg, Peter, Dipl.-Ing.

(56) Entgegenhaltungen:
- EP-A- 0 786 930
- DE-A- 4 230 418
- DE-U- 9 001 929

## Beschreibung

Die vorliegende Erfindung betrifft ein Gehäuse zur Aufnahme von elektrischen Baugruppen.

Es ist bekannt, Baugruppen in einzelnen Baugruppenträgern unterzubringen, welche dann in einen Schrank eingebaut werden. Die Entwärmung erfolgt durch freie bzw. erzwungene Konvektion des gesamten Schrankes. Nachteilig hierbei ist, daß der Schrank auch bei einem kleinen Ausbau komplett vorgeleistet werden muß. Dadurch entstehen insbesondere bei kleinen Ausbauten hohe Anschaffungskosten. Außerdem besitzt die Anlage in diesem Fall ein sehr großes, nicht benötigtes Volumen.

Eine andere Möglichkeit der Unterbringung von Baugruppen besteht darin, daß die einzelnen Baugruppen in Anlagen untergebracht sind und die kompletten Anlagen direkt aufeinander gestapelt werden. Dabei besitzt jede Anlage ihre eigene Entwärmung. Durch das Stapeln der kompletten Anlagen wird eine sehr große Bauhöhe erreicht. Als weiterer Nachteil kommt hier hinzu, daß nur einmal benötigte Teile (z.B. Brandschutzboden, Abdeckungen, usw. ) mehrmals verwendet werden, wodurch unnötige Kosten entstehen. Die Entwärmung ist ungünstig, da sie nicht direkt für die Stapelung optimiert ist.

Eine weitere Möglichkeit der Unterbringung von Baugruppen besteht darin, daß die Baugruppenträger direkt aufeinander gestapelt werden und durch ein Boden- und Deckelteil ergänzt werden. Hierbei tritt die Kühlluft am Bodenteil ein und am Deckel wieder aus. Nachteilig in diesem Falle ist, daß die höher liegenden Baugruppen immer durch die erwärmte Abluft der unteren erwärmt werden.

Aufgabe der vorliegenden Erfindung ist es, ein Gehäuse zur Aufnahme von elektrischen Baugruppen mit einer flexiblen mechanischen Verbindung von gestapelten Baugruppenträgern unter besonderer Berücksichtigung einer optimalen Entwärmung eines jeden Baugruppenträgers anzugeben.

Zur Lösung dieser Aufgabe besteht ein Gehäuse zur Aufnahme von elektrischen Baugruppen erfindungsgemäß aus:
mindestens einem Baugruppenträger, welcher im wesentlichen aus zwei Seitenteilen, die miteinander über obere und untere Führungsroste miteinander verbunden sind, besteht,
zwischen den einzelnen Baugruppenträgern angeordneten nach hinten hin offenen u-förmigen Verbindungslaschen, welche aus senkrecht verlaufenden gelochten Blechen bestehen, die bündig mit den Baugruppenträgern abschließen,
einem Bodenteil, bestehend aus einem Brandschutzboden und einer Bodenlasche, welche ähnlich wie die Verbindungslasche ausgebildet ist, und
einem Deckelteil, bestehend aus einer oberen Abdeckung und einer Deckellasche, welche ähnlich wie die Verbindungslasche ausgebildet ist,
wobei die Laschen jeweils mit dem Brandschutztboden und der oberen Abdeckung sowie den einzelnen Baugruppenträgern fest verbunden sind.

Die Vorteile des erfindungsgemäßen Gehäuses bestehen darin, daß die gesamte Anlage flexibel an die Erfordernisse der einzelnen Baugruppenträger anpaßbar ist. Es müssen keine Vorleistungen für einen kompletten Schrank erfolgen, und es gibt bei dem erfindungsgemäßen Gehäuse keine nicht benötigten Mehrteile wie bei gestapelten Komplettanlagen. Außerdem erfolgt eine optimale Anpassung des Gehäuses an die konkreten Anforderungen der Entwärmung.

Zweckmäßige Ausgestaltungen des erfindungsgemäßen Gehäuses ergeben sich aus den Unteransprüchen sowie aus der nachfolgenden Beschreibung eines Ausführungsbeispiels anhand der beigefügten Zeichnung.

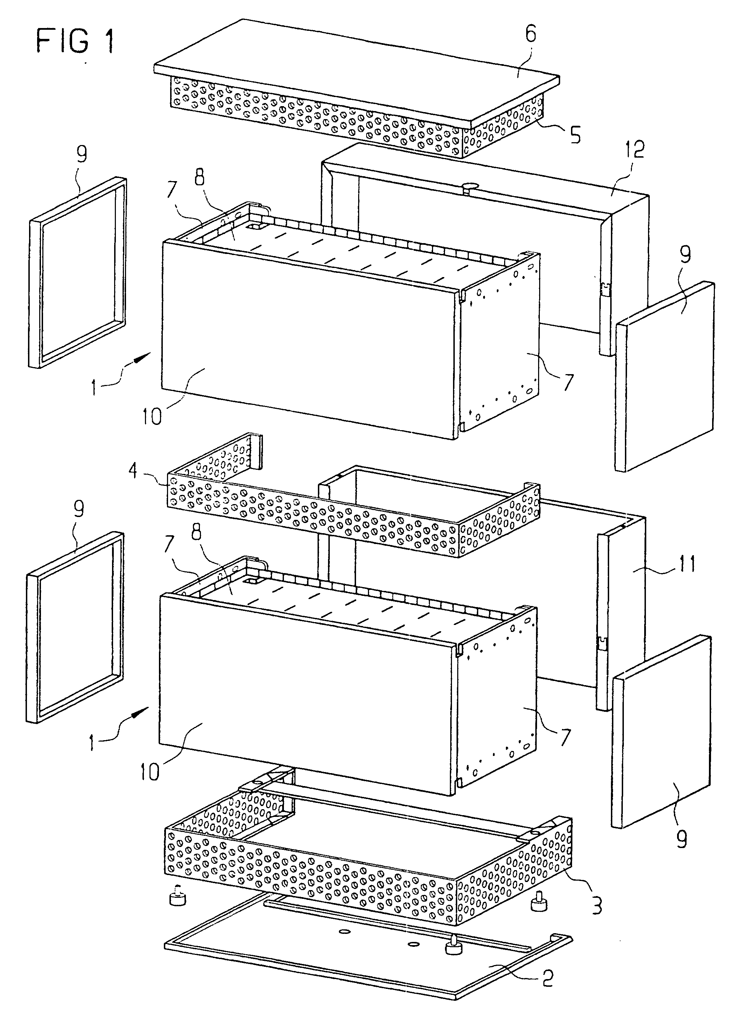

Es zeigen
Figur 1 eine Explosionsdarstellung eines Gehäuses zur Aufnahme von elektrischen Baugruppen gemäß der vorliegenden Erfindung,

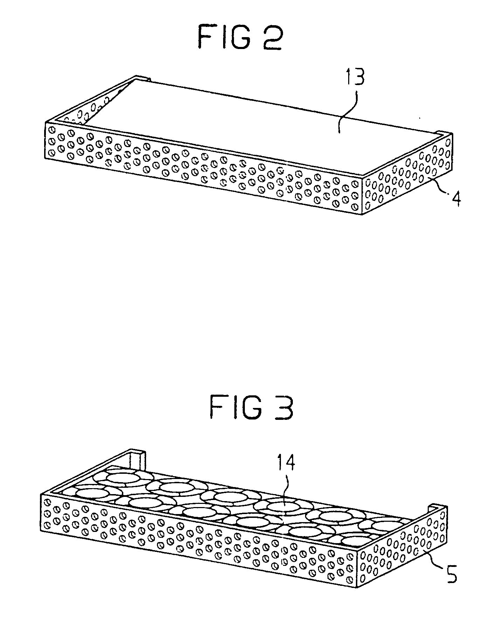

Figur 2 eine perspektivische Ansicht einer Verbindungslasche des in Figur 1 dargestellten Gehäuses mit einem Abluftblech,
Figur 3 eine perspektivische Ansicht einer Verbindungslasche des in Figur 1 dargestellten Gehäuses mit mehreren Ventilatoren,
Figur 4 eine perspektivische Ansicht einer Bodenlasche des in Figur 1 dargestellten Gehäuses im Betriebszustand, und
Figur 5 eine perspektivische Ansicht einer Bodenlasche des in Figur 1 dargestellten Gehäuses während des Bestückungszustandes.

Das dargestellte gemäß der vorliegenden Erfindung aufgebaute Gehäuse besteht im wesentlichen aus zwei Baugruppenträgern 1. Diese Baugruppenträger bestehen im wesentlichen aus zwei Seitenteilen 7 einem einem oberen Führungsrost 8 und einem unteren Führungsrost. In diese Baugruppenträger 1 sind nicht dargestellte Baugruppen einschiebbar.

Das erfindungsgemäße Gehäuse besteht aus einem Brandschutzboden 2 und einer Bodenlasche 3, auf welche der unterste Baugruppenträger 1 aufgesetzt wird.

Die Bodenlasche 3 besteht aus einem gelochten Blech, so daß eine Luftzirkulation möglich ist. Die Außenabmessungen der Bodenlasche 3 sind derart gewählt, daß sie bündig mit dem Baugruppenträger 1 abschließt.

Bei dem hier dargestellten Gehäuse ist auf dem unteren Baugruppenträger 1 eine Verbindungslasche 4 vorgesehen, welche ebenso wie die Bodenlasche 3 aus einem gelochten Blech besteht, um eine Luftzirkulation zu ermöglichen. Über der Verbindungslasche 4 ist ein weiterer Baugruppenträger 1 vorgesehen. Auf diesem oberen Baugruppenträger 1 ist eine Deckellasche 5, ebenfalls aus einem gelochten Blech bestehend, und eine obere Abdeckung 6 vorgesehen.

Weiterhin sind Seitenverkleidungen 9, frontseitige Verkleidungen 10 sowie rückseitige Verkleidungen 11 und 12 vorgesehen. Die rückseitigen Verkleidungen 11 und 12 sind so ausgelegt, daß sie die gesamte Anschlußverkabelung und Verbindungsverkabelung zwischen den einzelnen Baugruppen und Baugruppenträgern umschließen.

Das hier dargestellte Gehäuse gemäß der vorliegenden Erfindung besteht aus zwei Baugruppenträgern 1. Gemäß der vorliegenden Erfindung kann ein Gehäuse aber auch aus nur einem Baugruppenträger bzw. aus drei und mehr Baugruppenträgern 1 bestehen. Es ist zu erkennen, daß ohne Vorleistungen ein den Anforderungen entsprechendes Gehäuse erstellt werden kann, das bei gestiegenen Anforderungen ohne weiteres vergrößert werden kann. Dadurch, daß die Verbindungslaschen aus einem gelochten Blech bestehen, ist eine optimale Anpassung der Anlage an die konkreten Anforderungen der Entwärmung gegeben.

So ist es z.B. möglich, in einer Verbindungslasche ein Abluftblech 13 zur gezielten Luftführung vorzusehen. Weiterhin können in der Bodenlasche 3 oder in der Deckellasche 5 Ventilatoren 14 für eine gezielte Entwärmung vorgesehen werden.

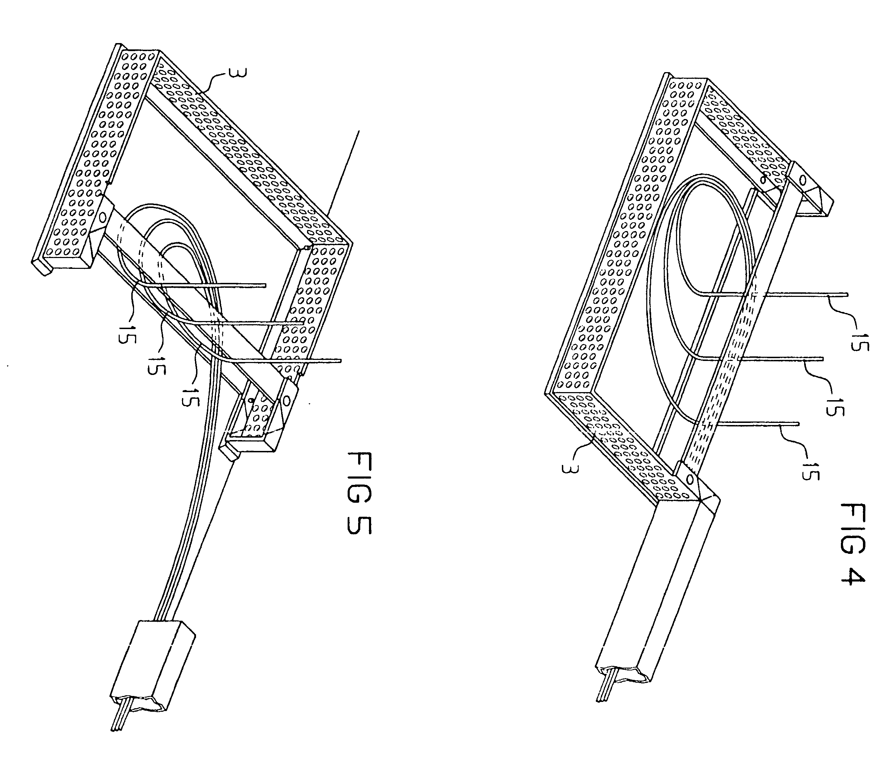

Die Bodenlasche kann, wie in den Figuren 4 und 5 dargestellt ist, zur Aufnahme von Kabelreserven 15 verwendet werden, so daß das Gehäuse während der Verkabelungsarbeiten leicht von seinem Standort an einer Wand abgerückt werden kann, ohne daß Anschlußkabel 15 demontiert werden müssen.

## Patentansprüche

1. Gehäuse zur Aufnahme von elektrischen Baugruppen, bestehend aus:
mindestens einem Baugruppenträger (1), welcher im wesentlichen aus zwei Seitenteilen (7), die miteinander über obere und untere Führungsroste (8) miteinander verbunden sind, besteht,
zwischen den einzelnen Baugruppenträgern (1) angeordneten nach hinten hin offenen u-förmigen Verbindungslaschen (4), welche aus senkrecht verlaufenden gelochten Blechen bestehen, die bündig mit den Baugruppenträgern (1) abschließen,
einem Bodenteil, bestehend aus einem Brandschutzboden (2) und einer Bodenlasche (3), welche ähnlich wie die Verbindungslasche (4) ausgebildet ist, und
einem Deckelteil, bestehend aus einer oberen Abdeckung (6) und einer Deckellasche (5), welche ähnlich wie die Verbindungslasche (4) ausgebildet ist,
wobei die Laschen (3, 4, 5) jeweils mit dem Brandschutzboden (2) und der oberen Abdeckung (6) sowie den einzelnen Baugruppenträgern (1) fest verbunden sind.

2. Gehäuse nach Anspruch 1,
**dadurch gekennzeichnet,**
**daß** die einzelnen Baugruppenträger (1) zwei Seitenverkleidungen (9) sowie eine frontseitige Verkleidung (10), die im wesentlichen wannenförmig ausgebildet sind, und eine rückseitige im wesentlichen u-förmige Verkleidung (11, 12) aufweisen, wobei die rückseitige Verkleidung (11, 12) derart ausgebildet ist, daß sie die rückseitige Verkabelung umgibt.

3. Gehäuse nach Anspruch 1 oder 2,
**dadurch gekennzeichnet,**
**daß** innerhalb einer Verbindungslasche (4) ein Zuluft- bzw. Abluftleitblech (13) angeordnet ist.

4. Gehäuse nach Anspruch 1 oder 2,
**dadurch gekennzeichnet,**
**daß** innerhalb einer Bodenlasche (3) bzw. Deckellasche (5) Belüftungsventilatoren (14) vorgesehen sind.

## Claims

1. Housing for electrical modules consisting of:
at least one subrack (1) consisting essentially of two side pieces (7) joined to each other by means of top and bottom guide grills (8),
U-shaped connecting frames (4) that are arranged between the individual subracks (1) with their open side to the rear and consist of vertically extending perforated metal sheets that end flush with the subracks (1),
a base component consisting of a fire protection base (2) and a base frame (3) of similar design to the connecting frame (4) and
a cover component consisting of a top cover (6) and a cover frame (5) of similar design to the connecting frame (4),
it being the case that the frames (3, 4, 5) are respectively fixedly connected to the fire protection base (2), the top cover (6) and the individual subracks (1).

2. Housing according to Claim 1,
**characterized in that**
the individual subracks (1) have two side panels (9) and a front panel (10) that are of an essentially dished design and a rear panel (11, 12) that is of an essentially U-shaped design, it being the case that the rear panel (11, 12) is designed such that it encloses the cabling at the rear.

3. Housing according to Claim 1 or 2,
**characterized in that**
an intake air baffle or an exhaust air baffle (13) is arranged inside a connecting frame (4).

4. Housing according to Claim 1 or 2,
**characterized in that**
ventilator fans (14) are provided inside a base frame (3) or cover frame (5).

## Revendications

1. Boîtier pour loger des modules électriques, constitué de :
au moins un châssis (1) équipé, qui est constitué pour l'essentiel de deux parties (7) latérales qui sont reliées entre elles par l'intermédiaire de grilles (8) de guidage supérieure et inférieure,
des pattes (4) de liaison en forme de U ouvert vers l'arrière, disposées entre les châssis (1) équipés individuels, qui sont constituées de tôles perforées s'étendant verticalement qui se terminent à affleurement avec les châssis (1) équipés,
une partie de fond, constituée d'un fond (2) anti-feu et d'une patte (3) de fond qui est conçue d'une manière analogue à la patte (4) de liaison, et
une partie de couvercle, constituée d'un élément (6) de recouvrement supérieur et d'une patte (5) de couvercle qui est conçue d'une manière analogue à la patte (4) de liaison,
les pattes (3, 4, 5) étant respectivement fixement assemblées au fond (2) anti-feu et à l'élément (6) de recouvrement supérieur ainsi qu'aux châssis (1) équipés individuels.

2. Boîtier suivant la revendication 1, **caractérisé en ce que** les châssis (1) équipés individuels comportent deux habillages (9) latéraux ainsi qu'un habillage (10) avant, qui sont réalisés essentiellement en forme de bacs, et un habillage (11, 12) arrière essentiellement en forme de U, l'habillage (11, 12) arrière étant conçu de telle sorte qu'il entoure le câblage arrière.

3. Boîtier suivant la revendication 1 ou 2, **caractérisé en ce qu'**une tôle (13) de guidage d'air entrant ou sortant est disposée à l'intérieur d'une patte (4) de liaison.

4. Boîtier suivant la revendication 1 ou 2, **caractérisé en ce que** des ventilateurs (14) d'aération sont prévus à l'intérieur d'une patte (3) de fond ou d'une patte (5) de couvercle.
